# EUROPEAN PATENT SPECIFICATION

(11) **EP 2 523 211 B1**
(45) Date of publication and mention of the grant of the patent: **23.10.2019**
(21) Application number: 11165403.4
(22) Date of filing: 10.05.2011
(51) Int. Cl.: H01L 21/56, H01L 23/31, H01L 23/495, H01L 23/00

(54) **Leadframe and method for packaging semiconductor die**
Leiterrahmen und Verfahren zum Verpacken von Halbleiterchips
Grille de connexion et procédé d'emballage de moule à semi-conducteur

(43) Date of publication of application: 14.11.2012
(73) Proprietor: Nexperia B.V., 6534 AB Nijmegen (NL)
(72) Inventor: Boettcher, Tim, 5656 AE Eindhoven (NL); Walczyk, Sven, 5656 AE Eindhoven (NL); Wong, Fei-Ying, 5656 AE Eindhoven (NL); Umali, Pompeo, 5656 AE Eindhoven (NL); Groenhuis, Roelf Anco Jacob, 5656 AE Eindhoven (NL); Rohrmoser, Bernd, 5656 AE Eindhoven (NL); Lee, SteveChiFai, 5656 AE Eindhoven (NL); Noren, Markus Bjoern Erik, 5656 AE Eindhoven (NL); Tsang, Paul Pang Hing, 5656 AE Eindhoven (NL)
(74) Representative: Crawford, Andrew

(56) References cited:
- US-A- 5 577 617
- US-A1- 2001 035 569
- US-A1- 2003 071 344
- US-A1- 2004 070 056
- US-A1- 2008 061 413
- US-A1- 2008 135 996

## Description

One of the major trends in the semiconductor packaging industry is to use surface-mount technology (SMT) as a replacement for conventional plated-through-hole (PTH) technology. SMT offers several distinct advantages over PTH technology, such as greater packaging density, higher lead counts with shorter interconnection lengths and easier automation. Since SMT requires electronic devices and components to be mountable on the surface of a printed circuit board (PCB) or substrate, the materials and structure of traditional through-hole components including capacitors, resistors, and inductors have to be redesigned to meet the modern-day demand for short, thin, light, and small electronic devices. Examples of semiconductor devices accomplishing these objects include quad flat non-leaded packages. Quad flat non-leaded packages have a package structure in which space-consuming outer leads protruding laterally out of a package are eliminated. Instead, external electrode pads to be electrically connected to a circuit board are provided on the bottom surface of the quad flat non-leaded package. The bottom surface of the package that connects to the circuit board may be referred to as the backside of the package as used herein.

A quad flat non-leaded package, especially a leadless leadframe package, makes use of a metal leadframe as a support structure in the packaging of a semiconductor die. Typically a plurality of leadframes are provided together in a strip of leadframes for packaging multiple dice. Each leadframe includes a die attach pad (die-pad) and one or more contacts (lead-pads) disposed about the leadframe. During assembly, dice are attached to the respective die-pads and wire bonding is used to electrically couple contacts of each die to their associated lead-pads. Wirebonding may be performed using a number of different methods including ball bonding, wedge bonding, etc. As used herein wirebonding is generically used to refer to various methods known in the art used to electrically couple contacts of a die to associated lead-pads. After the wire bonding process, the leadframes and dice are encapsulated by molding a packaging material, for example, a resin, over the top surface of the wire-bonded dice and leadframes. The encapsulated leadless leadframe packages are then singulated using conventional sawing. The packaged die may then be mounted on a printed circuit board (PCB). When mounted, the bottom surface of lead-pads and/or die-pads on the backside of the package connect with PCB contacts to connect the die with PBC circuitry.

US2008/0135996 relates to a lead frame for an electronic package that can insulate two or more stage units and support two or more stage

US2004/0070056 A1 relates to a lead frame and a method of manufacturing the same.

US2008/0061413 A1 relates to a semiconductor component having a semiconductor die and a lead frame.

The area of the die-pads and lead-pads on the backside of the package may be restricted to meet a set of design and layout rules. A design rule set specifies certain geometric and connectivity restrictions to ensure sufficient margins to account for variability in the manufacturing processes, ensure various electrical characteristics, and reduce area requirements of a circuit. However, it may be desirable to have a semiconductor die that is larger than the allowed area for the contact on the backside of the die-pad.

United States Patent Application Publication No. US2004/0070056 discloses a lead frame and method of manufacturing the same, the lead frame base frame having concave portions etched therein.

One or more embodiments may address one or more of the above issues.

In one embodiment, a method is provided for packaging a semiconductor die. A leadframe having a die-pad and one or more lead-pads is placed on an assembly surface. The die-pad has a base portion resting on the assembly surface, an upper portion on the base portion extending laterally from the base portion, and a support arm extending from and supporting the upper portion of die-pad. A semiconductor die is bonded to a top surface of the upper portion of the die-pad. The semiconductor die is wire bonded to the one or more lead-pads. The semiconductor die and leadframe are encased in a package material. The package material fills a space between the upper portion of the die-pad and the assembly surface. A portion of the support arm is removed.

In another embodiment, an intermediate structure is provided for making an electronic package. The intermediate structure includes a die-pad having a base portion and an upper portion above and extending laterally from the base portion. A semiconductor die is mounted on a top surface of the upper portion of the die-pad. A support arm extends from and supports the upper portion of the die-pad. The support arm extends beyond an area defined by the outline of the electronic package.

In yet another embodiment, an article of manufacture is provided. The article is characterized by a plurality of electronic packages arranged in a row or matrix. Each one of the electronic packages includes a die-pad and a semiconductor die mounted on a top surface of the die-pad. Between pairs of adjacent die-pads, respective connection arms connect the pairs of die-pads. A support arm extends from each connection arm and provides support for the die-pads connected thereto. The support arm extends into a cutting lane of the plurality of the electronic packages.

The above discussion is not intended to describe each embodiment or every implementation. Various example embodiments may be more completely understood in consideration of the following detailed description in connection with the accompanying drawings, in which:
FIG. 1 shows a perspective view of a die wirebonded on a leadframe;
FIG. 2 shows a side view of a die wirebonded on a leadframe;
FIG. 3 shows cross-section I, of the die wirebonded on the leadframe shown in FIG. 2;
FIG. 4 shows a top view of the die wirebonded on the leadframe shown in FIG. 2;
FIG. 5 shows a flowchart of a method for packaging a semiconductor die;
FIG. 6 shows a plurality of leadframes arranged in a row;
FIG. 7 illustrates mounting and wirebonding semiconductor dice on the plurality of leadframes shown in FIG. 6;
FIG. 8 illustrates encapsulation of the leadframes and dice in package material;
FIG. 9 illustrates removal of support tape from the encapsulated leadframes;
FIG. 10 illustrates separation of the encapsulated leadframes into separate electronic packages;
FIG. 11 shows a side view of a die wirebonded on a leadframe;
FIG. 12 shows a front view of the die wirebonded on the leadframe shown in FIG. 11; and
FIG. 13 shows a top view of the die wirebonded on the leadframe shown in FIG. 11.

While the disclosure is amenable to various modifications and alternative forms, examples thereof have been shown by way of example in the drawings and will be described in detail. It should be understood, however, that the intention is not to limit the disclosure to the particular embodiments shown and/or described. On the contrary, the intention is to cover all modifications, equivalents, and alternatives falling within the spirit and scope of the disclosure.

In one or more embodiments, a leadframe and method for die packaging are provided. The leadframe and method utilize one or more lead-pads and one or more die-pads. Each die-pad includes a base portion and an upper portion over the base portion. The upper portion is larger than the base portion and provides a die mounting surface that is larger than a die mounting surface that would be available with just the base portion. The upper portion extends laterally from the base portion. During assembly, however, the part of the upper portion that extends from the base portion may cause the die-pad to become unbalanced or unstable during the wirebonding and packaging processes. In one or more embodiments, a support arm is disposed in a cutting lane between die packages. The support arm provides support and increases stability of the die-pad during the wirebonding process. Once the die and die-pad are encapsulated in packaging material, support arms located in the cutting lanes are removed as a result of singulation of the packages.

It is recognized that the leadframe may include any number of die-pads and lead-pads to provide external contacts for respective contact pads of the die(s) included in each package. For ease of explanation, the embodiments and examples are primarily described with reference to a semiconductor package having two external contacts formed by a bottom surface of one die-pad and a bottom surface of one lead-pad.

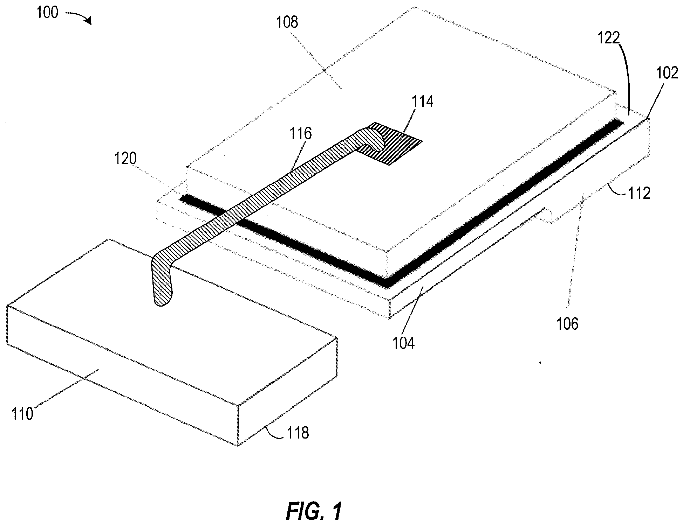

**FIG. 1** illustrates a leadframe having a die-pad with a die mount surface on an upper portion. In this example, the leadframe 100 includes one die-pad 102 and one lead-pad 110. The die-pad 102 has a base portion 106 and an upper portion 104 that extends laterally from the base portion 106. A bottom surface 112 of the base portion 106 and a bottom surface 118 of the lead-pad 110 form external contact terminals for the backside of the semiconductor package when packaging is completed. A semiconductor die 108 is mounted on a top surface 122 of the die-pad and affixed with a bonding material 120. The upper portion 104 of the die-pad 102 extending beyond the base portion 106 provides an area for die mounting that is greater in size than an area provided if only an area comparable in size to the base portion 106 were provided. During packaging, contact pads 114 of the semiconductor die 108 are electrically coupled to lead-pads 110 with a wirebond 116.

The base portion 106 of the die-pad 102 rests on an assembly surface during packaging. As discussed above, due to a particular design and associated design rules, the base portion 106 of the die-pad 102 may not provide adequate support for the die-pad. As a result, the weight of the semiconductor die 108 on the upper portion 104 or the forces of the wirebonding process may cause the die-pad 102 to tip, or otherwise become unbalanced during packaging. In one or more embodiments, the leadframe 100 is implemented to include a support arm (not shown) extending from the upper portion 104 of the die-pad 102 to provide stability to the die-pad during packaging. The support arm is formed in a cutting lane, outside dimensions of the complete packaged semiconductor die, so that the support arm is removed during the packaging process. Because the support arm is not present in the final package, the support arm does not conflict with any restrictions imposed by design rules.

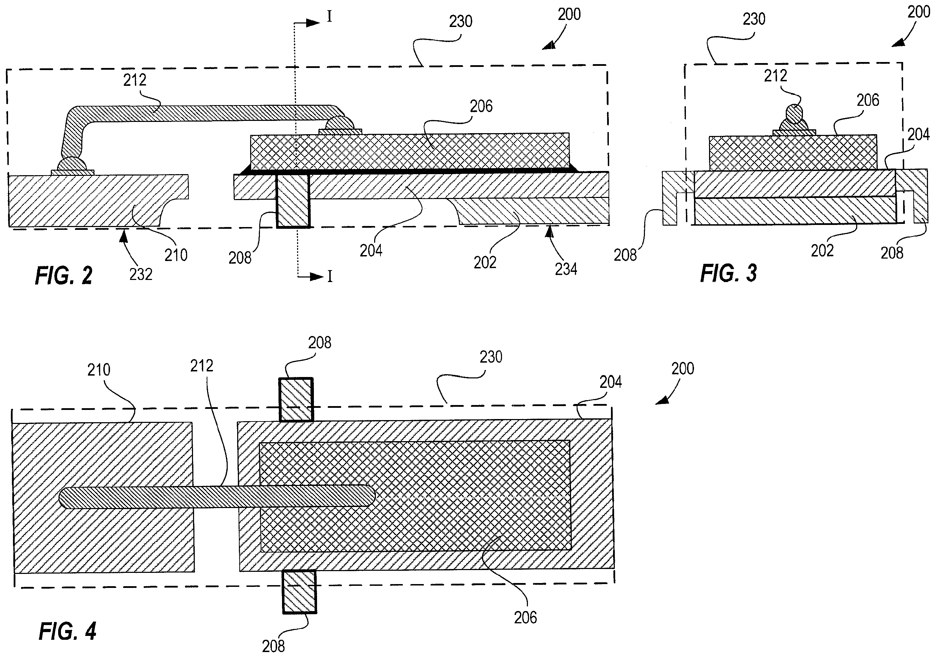

Various structures for supporting the die-pad may be located in the cutting lane, and outside the dimensions of what will eventually be the completed package. FIGs. 2-4 show a leadframe having an example support arm structure in the cutting lane. **FIG. 2** shows a side view of a die wirebonded on a leadframe, **FIG. 3** shows cross section I of the die wirebonded on the leadframe shown in FIG. 2, and **FIG. 4** shows a top view of the die wirebonded on the leadframe . The illustrated leadframe 200 includes a die-pad having a base portion 202 and an upper portion 204. In this example illustration, a semiconductor die 206 is mounted on the top surface of the die-pad, and a portion of the semiconductor die occupies an area of the upper portion 204 that is unsupported by the base portion 202. A contact of the semiconductor die 206 is wirebonded to a lead-pad 210 via wirebond 212. The wirebond 212 and lead-pad 210 form an electrical path from an external contact area on the bottom surface 232 of the lead-pad 210 to the semiconductor die 206.

Block 230 in FIGs. 2, 3, and 4 shows the outline of what will eventually be the completed package after singulation. A support arm 208 extends from and provides support for the upper portion 204. Prior to singulation of the package, the support arm 208 extends beyond the package outline 230 (FIGs. 3 and 4). In this embodiment, the support arm 208 extends laterally from the side of the upper portion 206, as shown in FIGs. 3 and 4, and downward to an extent that is generally co-planar with bottom surfaces 234 and 232 of the base portion 202 and lead-pad 210, respectively. Because the support arm 208 extends beyond the dimensions of the completed package 230, the support arm can be removed during singulation of multiple packages. Thus, once the packages have been singulated the support arms will have been removed and will not violate any design rules regulating contact area and location of the die-pad 202 and lead-pad 210

For purposes of explanation, base portion 202 and upper portion 204 of the die-pad are depicted as separate elements. It will be appreciated that the base portion 202 and upper portion 204 may be a monolithic structure. Likewise, support arm 208 may be integrally formed as part of the die-pad. Alternatively, the portions and support arm may be formed separately and attached as shown.

In some embodiments, the die-pad may be electrically coupled to a contact pad on the bottom of the semiconductor die. For example, the die contact may be electrically coupled to the die-pad using a conductive bonding substance, such as a conductive adhesive or a solderable material such as solder paste or solder. In some other embodiments, a contact pad of the semiconductor die may be wirebonded to the die-pad.

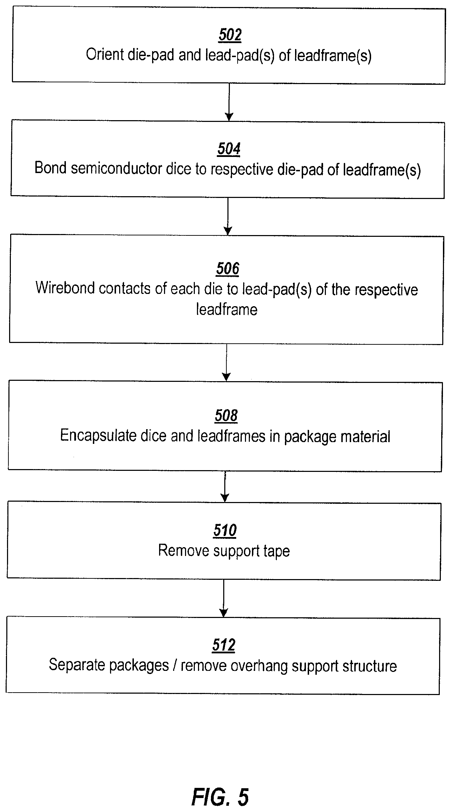

**FIG. 5** shows a flowchart of a method for packaging a semiconductor die. Die-pads and lead-pad(s) of leadframes are oriented on a manufacturing surface at process block 502. In some implementations, die-pads and lead-pads of leadframes may be pre-oriented and provided on support tape for ease of manufacturing. Semiconductor dice are bonded to the die-pads at block 504. The contacts of each die are wirebonded to lead-pads of the respective leadframe at block 506. The dice and leadframes are encapsulated in packaging material at block 508. Support tape, if used, is removed at block 510. The encapsulated dice and leadframes are cut into separate packages (singulated) at block 512. As a result of singulation, the support arms will have been removed from the finished package.

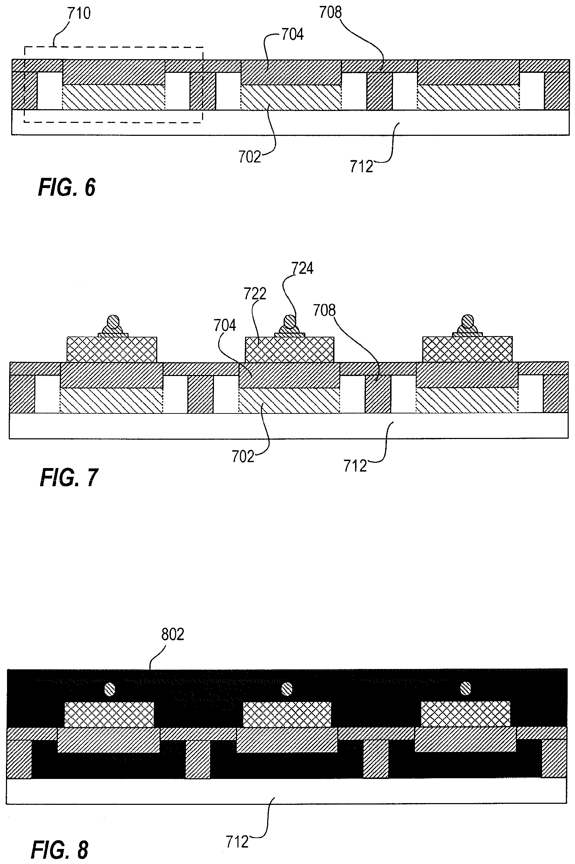

FIGs. 6-10 illustrate packaging a plurality of semiconductor dice according to the process shown in FIG. 5. **FIG. 6** shows a plurality of leadframes arranged in a row prior to diebonding. In this example illustration, each leadframe, for example, leadframe 710, is illustrated in cross section similar to that shown in FIG. 3. Each leadframe includes a die-pad having base portion 702 and an upper portion 704 that extends laterally from the base portion. A support arm 708 extends from and supports the upper portion of the die-pad. In this example, the leadframes are attached to support tape 712.

**FIG. 7** illustrates mounting and wirebonding semiconductor dice on the plurality of leadframes shown in FIG. 6. A semiconductor die 722 is mounted on the upper portion 704 of the die-pad. Contacts of the dice are wirebonded, via wirebonds 724, to one or more lead-pads (not shown).

**FIG. 8** illustrates encapsulation of the leadframes and dice in packaging material, such as a resin polymer. The die package is stabilized and sealed by applying packaging material over the leadframe carrier and dice by any suitable molding technique known in the art. For example, the body may be applied to the carrier by molding in a suitable mold tray. For example, the package material body may be formed by transfer or injection molding over the carrier. The packaging material body fully encapsulates the die-pad, die, and lead pad, filling any open spaces within the package dimensions, without covering the bottom surfaces of the die-pad and lead-pad since they are adhered to the tape 712. The bottom surfaces form external contacts on the backside of the package. The body of package material is cured and at least partially hardened, using techniques that are also known in the art, such as oven curing.

In this illustrative example, the leadframes are encapsulated together, with the packaging material filling the areas in the cutting lanes between the leadframes. In some embodiments, a portion of the support arm may be left exposed and not encased by packaging material.

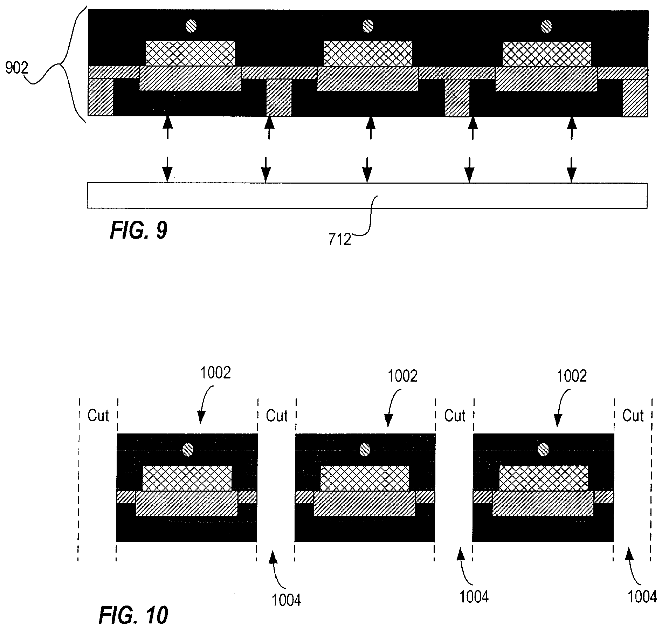

**FIG. 9** illustrates removal of support tape 712 from the plurality 902 of encapsulated leadframes and dice after curing. **FIG. 10** illustrates separation of the encapsulated leadframes into separate electronic packages. The packages, each of which includes one semiconductor die, are separated or singulated along a cutting lane 1004 between the individual ones of packages 1002. The singulation may be performed using techniques known to those skilled in the art. Once singulated, the packages may be electrically mounted to a substrate or printed circuit board.

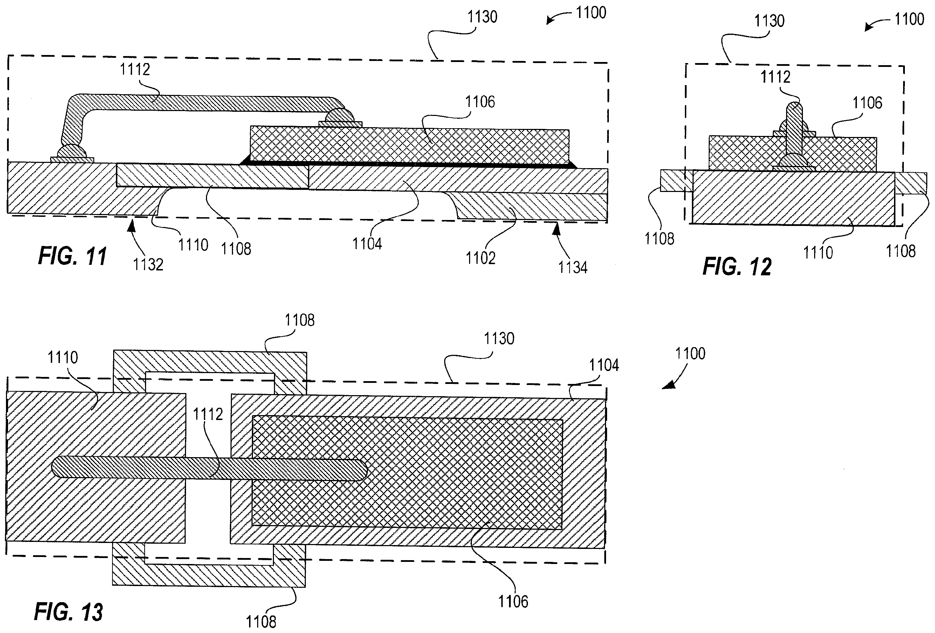

FIGs. 11-13 show a leadframe having an alternative structure for a support arm.

**FIG. 11** shows a side view of a die wirebonded on a leadframe, **FIG. 12** shows a front view of the die wirebonded on the leadframe shown in FIG. 11, and **FIG. 13** shows a top view of the die wirebonded on the leadframe shown in FIG. 11. The illustrated leadframe includes a die-pad having a base portion 1102 and an upper portion 1104. The upper portion extends laterally from the base portion. A bottom surface 1134 of the base portion 1102 of the die-pad and a bottom surface 1132 of the lead-pad 1110 form external contact terminals on the backside of the package when the package is complete. In this example illustration, a semiconductor die 1106 is mounted on the upper portion 1104 of the die-pad. The die 1106 is wirebonded to a lead-pad contact 1110 via wirebond 1112. A support arm 1108 supports a part of the upper portion 1104 that is not supported by the base portion 1102. The support is provided by way of the support arm being attached to both the upper portion 1104 and to the lead-pad 1110. A portion of the support arm 1108 is located in the cutting lane. In this manner, when the packages are singulated, the die-pad will not be electrically coupled to the lead-pad 1110 via the support arm.

## Claims

1. A method of packaging a semiconductor die, the method comprising the sequential steps of:
placing (502) a leadframe on an assembly surface, the leadframe having a die-pad (202/204) and one or more lead-pads (210), the die-pad having a base portion (202) resting on the assembly surface, an upper portion (204) on the base portion extending laterally from the base portion, and a support arm (208) extending from and supporting the upper portion of die-pad wherein the support arm (208) extends from the upper portion (204) of the die-pad down to the assembly surface;
bonding (504) a semiconductor die (206) to a top surface of the upper portion of the die-pad;
wirebonding (506) the semiconductor die to the one or more lead-pads (210), wherein a portion of the semiconductor die occupies an area of the upper portion (204) that is unsupported by the base portion (202);
encasing (508) the semiconductor die and leadframe in a package material (802), the package material filling a space between the upper portion of the die-pad and the assembly surface; and
removing (512) a portion of the support arm.

2. The method of claim 1, wherein the support arm couples the upper portion of the die pad to one of the one or more lead pads.

3. The method of claim 1, wherein the support arm couples the upper portion of the first mentioned die-pad to a second die pad (704).

4. The method of claim 1, wherein:
encasing the semiconductor die and leadframe in the package material encases the support arm (208) in the package material; and
removing the portion of the support arm includes removing a portion of the package material (1004) extending outside an area defined by dimensions of the packaged semiconductor die.

5. The method of claim 1, wherein encasing the semiconductor die and leadframe in the package material leaves the portion of the support arm (208), extending outside an area defined by the dimensions of the packaged semiconductor die, exposed.

6. The method of claim 1, wherein the die-pad has at least a second support arm (208) extending from the upper portion (204) of the die-pad.

7. The method of claim 6, wherein the second support arm extends from the upper portion in a direction opposite of the first mentioned support arm.

8. The method of claim 1, wherein:
the leadframe is coupled to a second like leadframe via the support arm (208); and
the portion of the support arm is removed by a process that includes separating the first mentioned leadframe from second like leadframe.

9. An intermediate structure for making an electronic package, comprising:
a die-pad having a base portion (202) and an upper portion (204) above and extending laterally from the base portion;
a semiconductor die (206) mounted on a top surface of the upper portion of the die-pad, wherein a portion of the semiconductor die occupies an area of the upper portion (204) that is unsupported by the base portion (202); and
a support arm (208) extending from and supporting the upper portion of the die-pad, the support arm extending beyond an area (230) defined by the electronic package, wherein the support arm extends from the upper portion of the die-pad to a plane of a bottom surface (112) of the base portion of the die-pad.

10. The intermediate structure of claim 9, wherein the support arm couples the upper portion of the die pad to a lead pad.

11. The intermediate structure of claim 9, wherein the support arm (208) couples the upper portion of the first mentioned die-pad to a second die pad (204).

12. The intermediate structure of claim 11, wherein the lead pad is wirebonded to the semiconductor die.

## Patentansprüche

1. Verfahren zur Kapselung eines Halbleiter-Chips, wobei das Verfahren folgende aufeinanderfolgende Schritte umfasst:
Platzieren (502) eines Leitergerüsts auf eine Montagefläche, wobei das Leitergerüst einen Chip-Pad (202/204) und einen oder mehrere Leiter-Pads (210) umfasst, wobei der Chip-Pad Folgendes aufweist: einen Basisabschnitt (202), der auf der Montagefläche aufliegt, einen oberen Abschnitt (204) auf dem Basisabschnitt, der sich seitlich von dem Basisabschnitt erstreckt, und einen Stützarm (208), der sich von dem oberen Abschnitt des Chip-Pads erstreckt und diesen stützt, wobei sich der Stützarm (208) von dem oberen Abschnitt (204) des Chip-Pads zu der Montagefläche herab erstreckt;
Bonden (504) eines Halbleiter-Chips (206) an eine obere Oberfläche des oberen Abschnitts des Chip-Pads;
Drahtbonden (506) des Halbleiter-Chips an den einen oder die mehreren Leiter-Pads (210), wobei ein Abschnitt des Halbleiter-Chips einen Bereich des oberen Abschnitts (204) belegt, der nicht von dem Basisabschnitt (202) gestützt wird;
Einschließen (508) des Halbleiter-Chips und des Leitergerüsts in einem Kapselungsmaterial (802), wobei das Kapselungsmaterial einen Raum zwischen dem oberen Abschnitt des Chip-Pads und der Montagefläche ausfüllt; und
Entfernen (512) eines Abschnitts des Stützarms.

2. Verfahren nach Anspruch 1, wobei der Stützarm den oberen Abschnitt des Chip-Pads an einen des einen oder der mehreren Leiter-Pads koppelt.

3. Verfahren nach Anspruch 1, wobei der Stützarm den oberen Abschnitt des erstgenannten Chip-Pads an einen zweiten Chip-Pad (704) koppelt.

4. Verfahren nach Anspruch 1, wobei:
das Einschließen des Halbleiter-Chips und des Leitergerüsts in dem Kapselungsmaterial den Stützarm (208) in dem Kapselungsmaterial einschließt; und
das Entfernen des Abschnitts des Stützarms das Entfernen eines Abschnitts des Kapselungsmaterials (1004) umfasst, der sich außerhalb eines von den Abmessungen des gekapselten Halbleiter-Chips definierten Bereichs erstreckt.

5. Verfahren nach Anspruch 1, wobei das Einschließen des Halbleiter-Chips und des Leitergerüsts in dem Kapselungsmaterial den Abschnitt des Stützarms (208), der sich außerhalb eines von den Abmessungen des gekapselten Halbleiter-Chips definierten Bereichs erstreckt, freigelegt lässt.

6. Verfahren nach Anspruch 1, wobei der Chip-Pad mindestens einen zweiten Stützarm (208) aufweist, der sich von dem oberen Abschnitt (204) des Chip-Pads erstreckt.

7. Verfahren nach Anspruch 6, wobei sich der zweite Stützarm von dem oberen Abschnitt in einer entgegengesetzten Richtung von dem erstgenannten Stützarm erstreckt.

8. Verfahren nach Anspruch 1, wobei:
das Leitergerüst über den Stützarm (208) an ein zweites gleiches Leitergerüst gekoppelt ist; und
der Abschnitt des Stützarms durch einen Prozess entfernt wird, der das Trennen des erstgenannten Leitergerüsts von dem zweiten gleichen Leitergerüst umfasst.

9. Zwischengebilde zum Herstellen eines Elektronik-Pakets, umfassend:
einen Chip-Pad mit einem Basisabschnitt (202) und einem oberen Abschnitt (204), der sich über dem Basisabschnitt befindet und sich seitlich davon erstreckt;
einen Halbleiter-Chip (206), der auf einer oberen Oberfläche des oberen Abschnitts des Chip-Pads angebracht ist, wobei ein Abschnitt des Halbleiter-Chips einen Bereich des oberen Abschnitts (204) belegt, der nicht von dem Basisabschnitt (202) gestützt wird; und
einen Stützarm (208), der sich von dem oberen Abschnitt des Chip-Pads erstreckt und diesen stützt, wobei sich der Stützarm über einen von dem Elektronik-Paket definierten Bereich (230) hinaus erstreckt, wobei sich der Stützarm von dem oberen Abschnitt des Chip-Pads zu einer Ebene einer unteren Oberfläche (112) des Basisabschnitts des Chip-Pads erstreckt.

10. Zwischengebilde nach Anspruch 9, wobei der Stützarm den oberen Abschnitt des Chip-Pads an einen Leiter-Pad koppelt.

11. Zwischengebilde nach Anspruch 9, wobei der Stützarm (208) den oberen Abschnitt des erstgenannten Chip-Pads an einen zweiten Chip-Pad (204) koppelt.

12. Zwischengebilde nach Anspruch 11, wobei der Leiter-Pad an den Halbleiter-Chip drahtgebondet ist.

## Revendications

1. Procédé de mise sous boîtier d'une puce semi-conductrice, le procédé comprenant les étapes séquentielles suivantes :
le placement (502) d'une grille de connexion sur une surface de montage, la grille de connexion présentant une plage de puce (202/204) et une ou plusieurs plages de connexion (210), la plage de puce présentant une partie de base (202) reposant sur la surface de montage, une partie supérieure (204) sur la partie de base s'étendant latéralement depuis la partie de base, et un bras de support (208) s'étendant depuis la partie supérieure de la plage de puce et supportant celle-ci, le bras de support (208) descendant depuis la partie supérieure (204) de la plage de puce jusqu'à la surface de montage ;
la fixation (504) d'une puce semi-conductrice (206) à une surface supérieure de la partie supérieure de la plage de puce ;
le microcâblage (506) de la puce semi-conductrice aux une ou plusieurs plages de connexion (210), dans lequel une partie de la puce semi-conductrice occupe une aire de la partie supérieure (204) qui n'est pas supportée par la partie de base (202) ;
l'encapsulation (508) de la puce semi-conductrice et de la grille de connexion dans un matériau de mise sous boîtier (802), le matériau de mise sous boîtier remplissant un espace entre la partie supérieure de la plage de puce et la surface de montage ; et
le retrait (512) d'une partie du bras de support.

2. Procédé selon la revendication 1, dans lequel le bras de support couple la partie supérieure de la plage de puce à une des une ou plusieurs plages de connexion.

3. Procédé selon la revendication 1, dans lequel le bras de support couple la partie supérieure de la première plage de puce mentionnée à une seconde plage de puce (704).

4. Procédé selon la revendication 1, dans lequel :
l'encapsulation de la puce semi-conductrice et de la grille de connexion dans le matériau de mise sous boîtier encapsule le bras de support (208) dans le matériau de mise sous boîtier; et
le retrait de la partie du bras de support comporte le retrait d'une partie du matériau de mise sous boîtier (1004) s'étendant en dehors d'une aire définie par des dimensions de la puce semi-conductrice mise sous boîtier.

5. Procédé selon la revendication 1, dans lequel l'encapsulation de la puce semi-conductrice et de la grille de connexion dans le matériau de mise sous boîtier laisse exposée la partie du bras de support (208) qui s'étend en dehors d'une aire définie par les dimensions de la puce semi-conductrice mise sous boîtier.

6. Procédé selon la revendication 1, dans lequel la plage de puce présente au moins un second bras de support (208) s'étendant depuis la partie supérieure (204) de la plage de puce.

7. Procédé selon la revendication 6, dans lequel le second bras de support s'étend depuis la partie supérieure dans un sens opposé du premier bras de support mentionné.

8. Procédé selon la revendication 1, dans lequel:
la grille de connexion est couplée à une seconde grille de connexion semblable par l'intermédiaire du bras de support (208) ; et
la partie du bras de support est retirée par un processus qui comporte la séparation de la première grille de connexion mentionnée de la seconde grille de connexion semblable.

9. Structure intermédiaire pour réaliser un boîtier électronique, comprenant :
une plage de puce présentant une partie de base (202) et une partie supérieure (204) au-dessus de la partie de base et s'étendant latéralement depuis cette dernière ;
une puce semi-conductrice (206) montée sur une surface supérieure de la partie supérieure de la plage de puce, dans laquelle une partie de la puce semi-conductrice occupe une aire de la partie supérieure (204) qui n'est pas supportée par la partie de base (202) ; et
un bras de support (208) s'étendant depuis la partie supérieure de la plage de puce et supportant celle-ci, le bras de support s'étendant au-delà d'une aire (230) définie par le boîtier électronique, dans laquelle le bras de support s'étend depuis la partie supérieure de la plage de puce jusqu'à un plan d'une surface inférieure (112) de la partie de base de la plage de puce.

10. Structure intermédiaire selon la revendication 9, dans laquelle le bras de support couple la partie supérieure de la plage de puce à une plage de connexion.

11. Structure intermédiaire selon la revendication 9, dans laquelle le bras de support (208) couple la partie supérieure de la première plage de puce mentionnée à une seconde plage de puce (204).

12. Structure intermédiaire selon la revendication 11, dans laquelle la plage de connexion est microcâblée à la puce semi-conductrice.
